# EUROPEAN PATENT SPECIFICATION

(11) **EP 3 798 498 B1**
(45) Date of publication and mention of the grant of the patent: **19.07.2023**
(21) Application number: 20197414.4
(22) Date of filing: 22.09.2020
(51) Int. Cl.: F21K 9/232, F21V 23/04, F21Y 113/13, F21Y 113/17, F21Y 115/10, H01L 25/075, H01L 33/48, H01L 33/62

(54) **LIGHTING APPARATUS**
BELEUCHTUNGSVORRICHTUNG
APPAREIL D'ÉCLAIRAGE

(30) Priority: 29.09.2019 CN 201921648183 U
(43) Date of publication of application: 31.03.2021
(73) Proprietor: Leedarson Lighting Co., Ltd., Zhangzhou, Fujian 363999 (CN)
(72) Inventor: CHEN, Yanbiao, Fujian, 363999 (CN); JIANG, Hongkui, Fujian, 363999 (CN)
(74) Representative: Häckel, Stefan

(56) References cited:
- WO-A1-2015/183591
- WO-A1-2016/026153
- CN-A- 103 453 348
- CN-A- 107 726 066
- US-A1- 2009 147 508
- US-A1- 2012 262 903
- US-A1- 2018 087 759

## Description

### Field

The present invention is related to a lighting apparatus, and more particularly related to a lighting apparatus with color adjustment function.

### Background

The time when the darkness is being lighten up by the light, human have noticed the need of lighting up this planet. Light has become one of the necessities we live with through the day and the night. During the darkness after sunset, there is no natural light, and human have been finding ways to light up the darkness with artificial light. From a torch, candles to the light we have nowadays, the use of light have been changed through decades and the development of lighting continues on.

Early human found the control of fire which is a turning point of the human history. Fire provides light to bright up the darkness that have allowed human activities to continue into the darker and colder hour of the hour after sunset. Fire gives human beings the first form of light and heat to cook food, make tools, have heat to live through cold winter and lighting to see in the dark.

Lighting is now not to be limited just for providing the light we need, but it is also for setting up the mood and atmosphere being created for an area. Proper lighting for an area needs a good combination of daylight conditions and artificial lights. There are many ways to improve lighting in a better cost and energy saving. LED lighting, a solid-state lamp that uses light-emitting diodes as the source of light, is a solution when it comes to energy-efficient lighting. LED lighting provides lower cost, energy saving and longer life span.

The major use of the light emitting diodes is for illumination. The light emitting diodes is recently used in light bulb, light strip or light tube for a longer lifetime and a lower energy consumption of the light. The light emitting diodes shows a new type of illumination which brings more convenience to our lives. Nowadays, light emitting diode light may be often seen in the market with various forms and affordable prices.

After the invention of LEDs, the neon indicator and incandescent lamps are gradually replaced. However, the cost of initial commercial LEDs was extremely high, making them rare to be applied for practical use. Also, LEDs only illuminated red light at early stage. The brightness of the light only could be used as indicator for it was too dark to illuminate an area. Unlike modern LEDs which are bound in transparent plastic cases, LEDs in early stage were packed in metal cases.

In 1878, Thomas Edison tried to make a usable light bulb after experimenting different materials. In November 1879, Edison filed a patent for an electric lamp with a carbon filament and keep testing to find the perfect filament for his light bulb. The highest melting point of any chemical element, tungsten, was known by Edison to be an excellent material for light bulb filaments, but the machinery needed to produce super-fine tungsten wire was not available in the late 19th century. Tungsten is still the primary material used in incandescent bulb filaments today.

Early candles were made in China in about 200 BC from whale fat and rice paper wick. They were made from other materials through time, like tallow, spermaceti, colza oil and beeswax until the discovery of paraffin wax which made production of candles cheap and affordable to everyone. Wick was also improved over time that made from paper, cotton, hemp and flax with different times and ways of burning. Although not a major light source now, candles are still here as decorative items and a light source in emergency situations. They are used for celebrations such as birthdays, religious rituals, for making atmosphere and as a decor.

Illumination has been improved throughout the times. Even now, the lighting device we used today are still being improved. From the illumination of the sun to the time when human can control fire for providing illumination which changed human history, we have been improving the lighting source for a better efficiency and sense. From the invention of candle, gas lamp, electric carbon arc lamp, kerosene lamp, light bulb, fluorescent lamp to LED lamp, the improvement of illumination shows the necessity of light in human lives.

There are various types of lighting apparatuses. When cost and light efficiency of LED have shown great effect compared with traditional lighting devices, people look for even better light output. It is important to recognize factors that can bring more satisfaction and light quality and flexibility.

It is beneficial to provide a lighting device that can be adjusted dynamically according to different scenarios. For example, in the day time or in the deep night, people may need different types of lights.

When such needs change dynamically, it is beneficial for providing a design for controlling the lighting apparatus to adjust quickly and conveniently.

### Summary

In some embodiments, a lighting apparatus includes a first LED module, a second LED module, a third LED module, and a light source plate.

The first LED module includes a first package frame disposing a first LED chip and a second LED chip.

The second LED module includes a second package frame disposing a third LED chip and a fourth LED chip.

The third LED module includes a third package frame disposing a fifth LED chip and a sixth LED chip.

The light source plate is used for mounting the first LED module, the second LED module and the third LED module.

A total number of red color type among the first LED chip, the second LED chip, the third LED chip, the fourth LED chip, the fifth LED chip and the sixth LED chip is more than a total number of green color type among the first LED chip, the second LED chip, the third LED chip, the fourth LED chip, the fifth LED chip and the sixth LED chip.

In some embodiment, the lighting apparatus is a light bulb device. In some other embodiments, the lighting apparatus may be a downlight device, a panel light device, a spot light device or other types of lighting devices.

In the bulb light example, the bulb light device may have a light source plate, e.g. an aluminum plate with a conductive layer, a heat dissipation layer and an insulation layer mounted with LED modules.

The LED modules have package frames. The package frames have internal wiring for connecting LED chips to external electrodes for receiving driving currents.

Different LED modules may be connected to a driver separately or may be connected in series, in parallel, partly in parallel and partly in series.

A bulb shell may be used for enclosing the LED modules. An Edison cap, with or without a heat sink cup portion may be attached to the bulb shell.

In some embodiments, the driver that is used for converting an external power source, e.g. 110V/220V alternating current to a direct current power source may be made as a module enclosed by the Edison cap.

Part of the components of the driver may be disposed on the same side or the opposite side as the LED modules on the light source plate.

The driver may have its own circuit board, which is plugged to the light source plate with elastic metal pins so as to eliminate welding process.

In some embodiments not according to the claimed invention, each LED module has more than two LED chips. According to the invention, each LED module has only two LED chips.

In embodiments not according to the claimed invention, when needed, the first LED module has only two LED chips, while the second LED module has more than two LED chips. However, it is found that according to the claimed invention, using only two LED chips meets certain optimization on light quality, assembly cost or some other factors.

According to the invention, among the LED chips in the first LED module, the second LED module and the third LED module, the number of red LED chips, which appear in all three LED modules have a larger number than the blue LED chips. The blue LED chips have a larger number than the green LED chips.

For example, the first LED module has a red LED chip and a green LED chip. The second LED module has a red LED chip and a blue LED chip. The third LED module has a red LED chip and a blue LED chip. In such configuration, there are three red LED chips, two blue LED chips and one green LED chip.

Other configuration may be set but at least the configuration mentioned above is found very effective on finding balance in light device design for ensuring sufficient red and blue light being produced.

In some embodiments, the lighting apparatus may also include an antenna module disposed at a center of the light source plate.

The antenna module has a protruding part from the light source plate.

The first LED module, the second LED module and the third LED module are disposed surrounding the antenna module.

People expect to add more functions and flexibility to light devices. Using wireless communication is an option. By using wireless communication, it is important to deploy an effective antenna to ensure signal quality.

In some embodiments, there is an antenna module disposed at a center of the light source plate. In the example of a bulb device, the light source plate may have a circular shape as a circular disk. In the center of the circular disk, an antenna module is disposed facing upwardly as the LED modules mentioned above toward the bulb shell.

In some embodiments, the antenna module has a plate and the plate has a protruding part protruding from a surface of the light source plate upwardly.

The LED modules are arranged surrounding the antenna module.

In some embodiments, the antenna module has a reflective layer for reflecting a light of the first LED module, the second LED module and the third LED module.

To more effectively increase light efficiency and decrease side effect of the protruding part of the antenna module, the antenna module may be added, painted or attached with a reflective layer for reflecting, instead of absorbing the light of the LED module, toward the bulb shell or other light passing cover and lens.

To further increase the light efficiency, the protruding part may have a tilt angle, designed for guiding the path and direction of the reflected light. Concave or Convex structures that may change light paths may be added to the light source module too.

In some embodiments, a fluorescent layer is disposed on the antenna module.

In some embodiments, the antenna module may be added in partial area or complete area with a fluorescent layer.

When a light emitted from the LED modules hits the fluorescent layer, a light with different wave spectrum may be generated. For example, a light with a first color is emitted on a fluorescent layer and then certain reflected light may be transformed to another color of light.

In some embodiments, the antenna module has a fourth LED module.

In some embodiments, when the antenna module has a protruding part, it is helpful to use the protruding part to add a light source or more light sources to add light emitted to cover more directions.

For example, one or multiple LED chips may be added on a plate of the antenna module. If the plate is a vertical board arising from the light source plate, the plate may be used for supporting the added light source, like a filament or a flexible filament mounted with LED chips.

The added light source may be used for mixing a desired light parameter with a driver.

In some embodiments, the fourth LED module may be used for providing a status of the wireless module or the driver, e.g. a blinking red light showing a first status while a green light showing another status, e.g. everything is ok for the smoke detector integrated with the lighting apparatus.

In some embodiments, the fourth LED module emits a light to a light guide of the antenna module.

In some embodiments, the plate of the antenna module may have a light guide. The light guide may be made of plastic transparent materials with lots of micro dots on a surface for guiding light to emit from the micro dots.

In addition to increase visual effect, the light guide also changes light paths and guides the light direction to emit at desired positions. It would therefore provide much more flexibility when being combined with driver control.

In some embodiments, a driver circuit is attached on the antenna module.

As mentioned above, the first LED module, the second LED module and the third LED module are controlled by a driver which provides driving currents.

In some embodiments, a portion of the driver circuit of the driver are mounted on the antenna module or completely mounted on the antenna module.

A portion of the antenna module may be exposed and protruding above the light source plate while another portion of the antenna module may be disposed below the light source plate.

By integrating the antenna module and the driver makes assembly easier and provides better reliability of the lighting device.

In some embodiments, the antenna module receives an external command from an external device via the antenna module to activate an eye protection mode for lowering a light intensity of a blue LED device from the first LED module, the second LED module and the third LED module.

A remote control like a mobile phone installed with an associated App may be used for communicating with the antenna module which provides an antenna to a wireless circuit of the driver.

The external command is received from the antenna of the antenna module and decoded by a wireless circuit disposed on the antenna module or integrated with the driver.

The external command may be translated as a mode selection from multiple options.

In some embodiments, the mode selection may be related to an eye protection mode. In the eye protection mode, the blue LED chip on the LED modules mentioned above may be turned off or their intensity being decreased to prevent blue light hurting human eyes.

Such working mode may have some drawbacks but make some users more comfortable when the light spectrum is not expected to cover full range.

In some embodiments, the antenna module receives an external command of an external device from the antenna module to activate a sleep mode for lowering a light intensity of a blue LED device and increasing a light intensity of a red LED device of the first LED module, the second LED module and the third LED module.

In some other option modes, the external command may indicate the wireless circuit of the driver to control the LED modules to lower blue light while adding more red light in a sleep mode.

It is found that with more red lights or lower frequency light, people get sleep or feel more comfortable at night when they do not need to read books or take pictures which may need a more complete light spectrum covering.

In short, the external command may be an abstract command as a sleep mode or an eye protection mode. The drivers at different lighting apparatuses determine respectively a corresponding configuration to achieve the effect of the abstract command.

In such design, the external command does not indicate specifically how to control the LED modules directly.

Instead, the external command from a remote control or a sever that is located at a living room or a remote server room may be configured to indicate a request.

The request is translated by the driver so as to generate corresponding control signals or driving currents for the LED modules.

In some embodiments, the antenna module receives an external command of an external device from the antenna module to activate a color rendering mode optimized for an object type by controlling light intensity parameters of the first LED module, the second LED module and the third LED module.

In some embodiments, users may select a color rendering mode optimized for specific type of objects.

Different light combination may provide better visual rendering effect, color rendering index, for different objects, like vegetable, clothing, metal pieces, food or any objects in different scenarios and different marketing purposes.

Users may use the external command to indicate an object type to be optimized, e.g. green vegetable, fresh fish, and the driver determines a corresponding settings to drive the LED modules.

A color configuration or a function with program codes may be transmitted to the driver to implement such function, too.

According to the invention, the total number of red color type among the first LED chip, the second LED chip, the third LED chip, the fourth LED chip, the fifth LED chip and the sixth LED chip is more than a total number of blue color type among the first LED chip, the second LED chip, the third LED chip, the fourth LED chip, the fifth LED chip and the sixth LED chip.

According to the invention, the total number of blue color type among the first LED chip, the second LED chip, the third LED chip, the fourth LED chip, the fifth LED chip and the sixth LED chip is more than the total number of green color type among the first LED chip, the second LED chip, the third LED chip, the fourth LED chip, the fifth LED chip and the sixth LED chip.

In some embodiments, the first LED chip is a red color LED device, the second LED chip is a green color LED device, the third LED chip is a red LED device, the fourth LED chip is a blue LED device, the fifth LED chip is a red LED device, and the sixth LED chip is a blue LED device.

In some embodiments, the LED devices of the same color in the first LED module, the second LED module and the third LED module are connected in series and controlled at the same time.

The LED devices of different colors in the first LED module, the second LED module and the third LED module are controlled separately.

In some embodiments, the lighting apparatus may also include a first white LED module with a first color temperature.

The first white LED module is disposed on the light source plate.

The first white LED module may have a color temperature mainly close to 5000K, as a high color temperature white LED module.

Even the same white LED modules may emit lights of different color temperatures. It is helpful to deploy a white LED module with a certain range of color temperature to adjust the overall light parameter.

In some embodiments, the lighting apparatus may also include a second white LED module with a second color temperature.

The second color white LED module is disposed on the light source plate, and the first color temperature is higher than the second color temperature.

Another white LED module with lower color temperature, e.g. 2000K, may be used together with the first white LED module.

The number 5000K and 2000K may be added with a range separately. For example, the 5000K color temperature may be 3500K to 6500K, and the 2000K color temperature may be 500K to 3500K.

In some embodiments, the first white LED module and the second white LED module are placed more closer than an peripheral edge than the first LED module, the second LED module and the third LED module.

In some embodiments, the first LED module, the second LED module and the third LED module are arranged at center of the light source plate while the first white LED module and the second white LED module are placed at peripheral positions of the light source plate.

It is found such arrangement provides a better light effect in some design requirements.

In some embodiments, a driver is used for supplying driving currents to the first LED module, the second LED module and the third LED module with a PWM circuit.

One LED chip of each of the first LED module, the second LED module and the third LED module is turned off when the other LED chip of each of the first LED module, the second LED module and the third LED module is turned on.

PWM (Pulse Width Modulation) is used for generating a driving current alternatively, to turn on and to turn off at a high frequency.

By adjusting the total time span in which the driving current is turned on, the light intensity of a corresponding LED chip is adjusted.

In some embodiments, the first LED module, the second LED module and the third LED module each has two LED chips. The two LED chips are turned on and turned off at different timing.

Specifically, when one LED chip is turned on at time t0, the other LED chip is turned off at time t0. When the other LED chip is turned on at time t1, the one LED chip is turned off at time t1.

Only one LED chip is turned on together with the PWM control to make the overall circuit design more elegant and reliable.

In some embodiments, the package frame has a metal pad for mounting the first LED chip has an inwardly concave corner.

The package frame may be made of plastic material. To mount the LED chips in a LED module, two or more metal pads are disposed for mounting the LED chips.

Specifically, when there are two LED chips in one LED module, each LED chip is assigned two metal pads for connecting to a positive terminal and a negative terminal of a power source.

There are four metal pads disposed in the package frame and the four external corners of the overall metal pads are cut inwardly to form four inwardly concave corner to increase reliability and current quality of the LED module.

In some embodiments, two LED chips of the first LED module, the second LED module and the third LED module have independent conductive paths connecting to a driver.

Specifically, the first LED chip is routed to the driver with a conductive path independent from another conductive path for connecting the second LED chip in the same LED module.

The LED chips with the same color may be connected with the same conductive path. For example, all red LED chips on different LED modules are connected and controlled together by the driver for arranging the red LED chips in the same conductive path.

### Brief Description of Drawings

- Fig. 1: illustrates a lighting apparatus of a light bulb example.
- Fig. 2: illustrates a top view of a light source plate mounted with LED modules.
- Fig. 3: illustrates a LED module example with two LED chips in a package frame.
- Fig. 4: illustrates a cross sectional view of a LED module example.
- Fig. 5: illustrates conductive path example on routing power connecting multiple LED chips among LED modules.
- Fig. 6: illustrates a circuit diagram for implementing a lighting apparatus.
- Fig. 7: illustrates a top view of a light source plate.
- Fig. 8: illustrates a light bulb apparatus example.

### Detailed Description

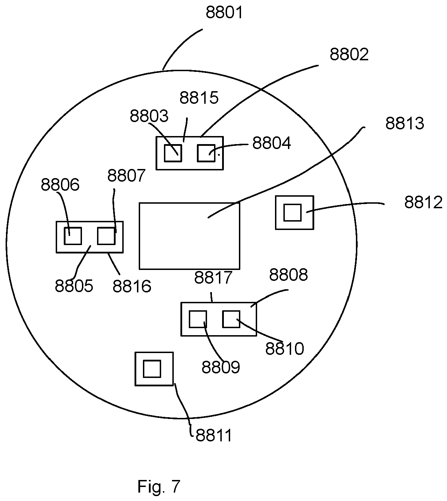

In Fig. 7, a lighting apparatus includes a first LED module 8802, a second LED module 8805, a third LED module 8808, and a light source plate 8801.

The first LED module 8802 includes a first package frame 8815 disposing a first LED chip 8803 and a second LED chip 8804.

The second LED module 8805 includes a second package frame 8816 disposing a third LED chip 8806 and a fourth LED chip 8807.

The third LED module 8808 includes a third package frame 8817 disposing a fifth LED chip 8809 and a sixth LED chip 8810.

The light source plate 8801 is used for mounting the first LED module 8802, the second LED module 8805 and the third LED module 8808.

A total number of red color type among the first LED chip, the second LED chip, the third LED chip, the fourth LED chip, the fifth LED chip and the sixth LED chip is more than a total number of green color type among the first LED chip, the second LED chip, the third LED chip, the fourth LED chip, the fifth LED chip and the sixth LED chip.

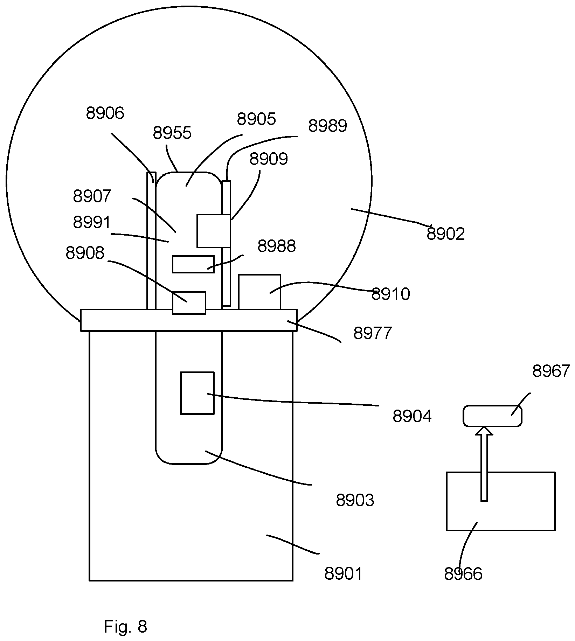

In Fig. 8, the lighting apparatus is a light bulb device. In some other embodiments, the lighting apparatus may be a downlight device, a panel light device, a spot light device or other types of lighting devices.

In Fig. 8, the bulb light device may have a light source plate 8977, e.g. an aluminum plate with a conductive layer, a heat dissipation layer and an insulation layer mounted with LED modules 8910.

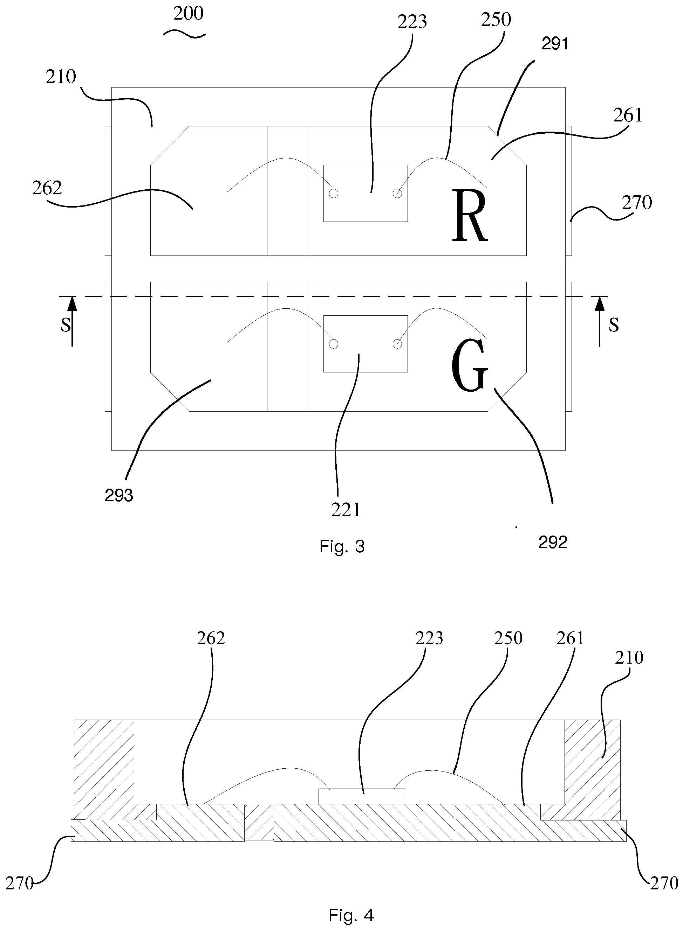

The LED modules have package frames, with examples in Fig. 3 and Fig. 4. The package frames have internal wiring for connecting LED chips to external electrodes for receiving driving currents.

In Fig. 8, different LED modules 8910 may be connected to a driver 8904 separately or may be connected in series, in parallel, partly in parallel and partly in series.

A bulb shell 8902 may be used for enclosing the LED modules 8910. An Edison cap 8901, with or without a heat sink cup portion may be attached to the bulb shell.

In some embodiments, the driver that is used for converting an external power source, e.g. 110V/220V alternating current to a direct current power source may be made as a module enclosed by the Edison cap.

Part of the components of the driver may be disposed on the same side or the opposite side as the LED modules on the light source plate. For example, the antenna module has a top part 8905 and a bottom part 8903 in Fig. 8.

The top part 8905 may be used for disposing an antenna 8988. A portion of complete components of circuit components of the driver may be placed at the bottom part 8903 or 8905 depending on different design requirements.

The driver may have its own circuit board, which is plugged to the light source plate with elastic metal pins so as to eliminate welding process.

In embodiments not according to the claimed invention, each LED module has more than two LED chips. According to the invention, each LED module has only two LED chips.

In embodiments not according to the claimed invention, when needed, the first LED module has only two LED chips, while the second LED module has more than two LED chips. However, it is found that according to the invention, using only two LED chips meets certain optimization on light quality, assembly cost or some other factors.

According to the invention, among the LED chips in the first LED module, the second LED module and the third LED module, the number of red LED chips, which appear in all three LED modules have a larger number than the blue LED chips. The blue LED chips have a larger number than the green LED chips.

For example, the first LED module has a red LED chip and a green LED chip. The second LED module has a red LED chip and a blue LED chip. The third LED module has a red LED chip and a blue LED chip. In such configuration, there are three red LED chips, two blue LED chips and one green LED chip.

Other configuration may be set but at least the configuration mentioned above is found very effective on finding balance in light device design for ensuring sufficient red and blue light being produced.

In some embodiments, the lighting apparatus may also include an antenna module disposed at a center of the light source plate.

The antenna module has a protruding part as the top part 8905 from the light source plate 8977.

The first LED module, the second LED module and the third LED module are disposed surrounding the antenna module, as illustrated in Fig. 7.

People expect to add more functions and flexibility to light devices. Using wireless communication is an option. By using wireless communication, it is important to deploy an effective antenna to ensure signal quality.

In some embodiments, there is an antenna module disposed at a center of the light source plate. In the example of a bulb device, the light source plate may have a circular shape as a circular disk. In the center of the circular disk, an antenna module is disposed facing upwardly as the LED modules mentioned above toward the bulb shell.

In some embodiments, the antenna module has a plate and the plate has a protruding part protruding from a surface of the light source plate upwardly.

The LED modules are arranged surrounding the antenna module.

In some embodiments, the antenna module has a reflective layer 8906 for reflecting a light of the first LED module, the second LED module and the third LED module.

To more effectively increase light efficiency and decrease side effect of the protruding part of the antenna module, the antenna module may be added, painted or attached with a reflective layer for reflecting, instead of absorbing the light of the LED module, toward the bulb shell or other light passing cover and lens.

To further increase the light efficiency, the protruding part may have a tilt angle, e.g. to bend the reflective layer 8906 with a certain tilt angle, designed for guiding the path and direction of the reflected light. Concave or Convex structures that may change light paths may be added to the light source module too.

In Fig. 8, a fluorescent layer 8989 is disposed on the antenna module 8955.

In some embodiments, the antenna module may be added in partial area or complete area with a fluorescent layer.

When a light emitted from the LED modules hits the fluorescent layer, a light with different wave spectrum may be generated. For example, a light with a first color is emitted on a fluorescent layer and then certain reflected light may be transformed to another color of light.

In some embodiments, the antenna module has a fourth LED module 8909, 8908.

In some embodiments, when the antenna module has a protruding part, it is helpful to use the protruding part to add a light source or more light sources to add light emitted to cover more directions.

For example, one or multiple LED chips may be added on a plate of the antenna module. If the plate is a vertical board arising from the light source plate, the plate may be used for supporting the added light source, like a filament or a flexible filament mounted with LED chips.

The added light source may be used for mixing a desired light parameter with a driver.

In some embodiments, the fourth LED module may be used for providing a status of the wireless module or the driver, e.g. a blinking red light showing a first status while a green light showing another status, e.g. everything is ok for the smoke detector integrated with the lighting apparatus.

In some embodiments, the fourth LED module emits a light to a light guide 8991 of the antenna module 8955.

In some embodiments, the plate of the antenna module may have a light guide. The light guide may be made of plastic transparent materials with lots of micro dots on a surface for guiding light to emit from the micro dots.

In addition to increase visual effect, the light guide also changes light paths and guides the light direction to emit at desired positions. It would therefore provide much more flexibility when being combined with driver control.

In some embodiments, a driver circuit is attached on the antenna module.

As mentioned above, the first LED module, the second LED module and the third LED module are controlled by a driver which provides driving currents.

In some embodiments, a portion of the driver circuit of the driver are mounted on the antenna module or completely mounted on the antenna module.

A portion of the antenna module may be exposed and protruding above the light source plate while another portion of the antenna module may be disposed below the light source plate.

By integrating the antenna module and the driver makes assembly easier and provides better reliability of the lighting device.

In Fig. 8, the antenna module receives an external command 8967 from an external device 8966 via the antenna module to activate an eye protection mode for lowering a light intensity of a blue LED device from the first LED module, the second LED module and the third LED module.

A remote control like a mobile phone installed with an associated App may be used for communicating with the antenna module which provides an antenna to a wireless circuit of the driver.

The external command is received from the antenna of the antenna module and decoded by a wireless circuit disposed on the antenna module or integrated with the driver.

The external command may be translated as a mode selection from multiple options.

In some embodiments, the mode selection may be related to an eye protection mode. In the eye protection mode, the blue LED chip on the LED modules mentioned above may be turned off or their intensity being decreased to prevent blue light hurting human eyes.

Such working mode may have some drawbacks but make some users more comfortable when the light spectrum is not expected to cover full range.

In some embodiments, the antenna module receives an external command of an external device from the antenna module to activate a sleep mode for lowering a light intensity of a blue LED device and increasing a light intensity of a red LED device of the first LED module, the second LED module and the third LED module.

In some other option modes, the external command may indicate the wireless circuit of the driver to control the LED modules to lower blue light while adding more red light in a sleep mode.

It is found that with more red lights or lower frequency light, people get sleep or feel more comfortable at night when they do not need to read books or take pictures which may need a more complete light spectrum covering.

In short, the external command may be an abstract command as a sleep mode or an eye protection mode. The drivers at different lighting apparatuses determine respectively a corresponding configuration to achieve the effect of the abstract command.

In such design, the external command does not indicate specifically how to control the LED modules directly.

Instead, the external command from a remote control or a sever that is located at a living room or a remote server room may be configured to indicate a request.

The request is translated by the driver so as to generate corresponding control signals or driving currents for the LED modules.

In some embodiments, the antenna module receives an external command of an external device from the antenna module to activate a color rendering mode optimized for an object type by controlling light intensity parameters of the first LED module, the second LED module and the third LED module.

In some embodiments, users may select a color rendering mode optimized for specific type of objects.

Different light combination may provide better visual rendering effect, color rendering index, for different objects, like vegetable, clothing, metal pieces, food or any objects in different scenarios and different marketing purposes.

Users may use the external command to indicate an object type to be optimized, e.g. green vegetable, fresh fish, and the driver determines a corresponding setting to drive the LED modules.

A color configuration or a function with program codes may be transmitted to the driver to implement such function, too.

According to the invention, the total number of red color type among the first LED chip, the second LED chip, the third LED chip, the fourth LED chip, the fifth LED chip and the sixth LED chip is more than a total number of blue color type among the first LED chip, the second LED chip, the third LED chip, the fourth LED chip, the fifth LED chip and the sixth LED chip.

According to the invention, the total number of blue color type among the first LED chip, the second LED chip, the third LED chip, the fourth LED chip, the fifth LED chip and the sixth LED chip is more than the total number of green color type among the first LED chip, the second LED chip, the third LED chip, the fourth LED chip, the fifth LED chip and the sixth LED chip.

In some embodiments, the first LED chip is a red color LED device, the second LED chip is a green color LED device, the third LED chip is a red LED device, the fourth LED chip is a blue LED device, the fifth LED chip is a red LED device, and the sixth LED chip is a blue LED device.

In some embodiments, the LED devices of the same color in the first LED module, the second LED module and the third LED module are connected in series and controlled at the same time.

The LED devices of different colors in the first LED module, the second LED module and the third LED module are controlled separately.

In some embodiments, the lighting apparatus may also include a first white LED module with a first color temperature.

The first white LED module is disposed on the light source plate.

The first white LED module may have a color temperature mainly close to 5000K, as a high color temperature white LED module.

Even the same white LED modules may emit lights of different color temperatures. It is helpful to deploy a white LED module with a certain range of color temperature to adjust the overall light parameter.

In some embodiments, the lighting apparatus may also include a second white LED module with a second color temperature.

The second color white LED module is disposed on the light source plate, and the first color temperature is higher than the second color temperature.

Another white LED module with lower color temperature, e.g. 2000K, may be used together with the first white LED module.

The number 5000K and 2000K may be added with a range separately. For example, the 5000K color temperature may be 3500K to 6500K, and the 2000K color temperature may be 500K to 3500K.

In some embodiments, the first white LED module and the second white LED module are placed more closer than a peripheral edge than the first LED module, the second LED module and the third LED module.

In some embodiments, the first LED module, the second LED module and the third LED module are arranged at center of the light source plate while the first white LED module and the second white LED module are placed at peripheral positions of the light source plate.

It is found such arrangement provides a better light effect in some design requirements.

In some embodiments, a driver is used for supplying driving currents to the first LED module, the second LED module and the third LED module with a PWM circuit.

One LED chip of each of the first LED module, the second LED module and the third LED module is turned off when the other LED chip of each of the first LED module, the second LED module and the third LED module is turned on.

PWM (Pulse Width Modulation) is used for generating a driving current alternatively, to turn on and to turn off at a high frequency.

By adjusting the total time span in which the driving current is turned on, the light intensity of a corresponding LED chip is adjusted.

In some embodiments, the first LED module, the second LED module and the third LED module each has two LED chips. The two LED chips are turned on and turned off at different timing.

Specifically, when one LED chip is turned on at time t0, the other LED chip is turned off at time t0. When the other LED chip is turned on at time t1, the one LED chip is turned off at time t1.

Only one LED chip is turned on together with the PWM control to make the overall circuit design more elegant and reliable.

In Fig. 3, the package frame 210 has a metal pad 261 for mounting the first LED chip 223 has an inwardly concave corner 291.

The package frame may be made of plastic material. To mount the LED chips in a LED module, two or more metal pads are disposed for mounting the LED chips.

Specifically, when there are two LED chips in one LED module, each LED chip is assigned two metal pads 261, 292 for connecting to a positive terminal and a negative terminal of a power source.

There are four metal pads 261, 292, 262, 293 disposed in the package frame and the four external corners 291 of the overall metal pads are cut inwardly to form four inwardly concave corner to increase reliability and current quality of the LED module.

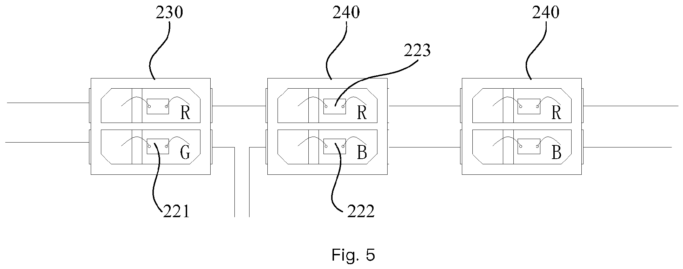

In some embodiments, two LED chips of the first LED module, the second LED module and the third LED module have independent conductive paths connecting to a driver as illustrated in Fig. 5.

Specifically, the first LED chip is routed to the driver with a conductive path independent from another conductive path for connecting the second LED chip in the same LED module.

The LED chips with the same color may be connected with the same conductive path. For example, all red LED chips on different LED modules are connected and controlled together by the driver for arranging the red LED chips in the same conductive path.

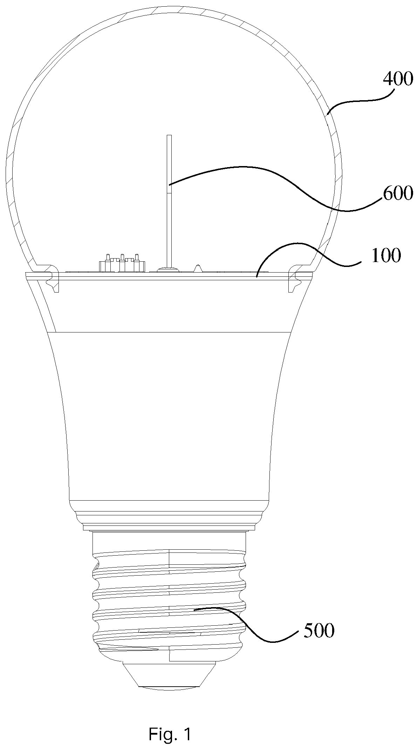

Please refer to Fig. 1, which illustrates a light bulb example.

In Fig. 1, a bulb shell 400 covers a light source plate 100. There is an antenna module 600 disposed at a center of the light source plate 100. An Edison cap 500 is attached to the bulb shell 400.

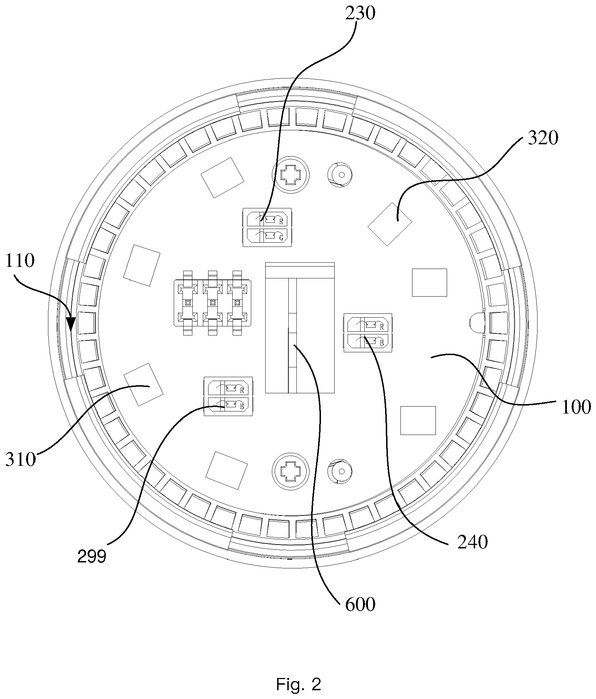

In Fig. 2, a top view of the light source plate is illustrated.

In Fig. 2, the light source plate has holes for fixing or plugging to the Edison cap or a heat sink cup. A first LED chip 230, a second LED module 299 and a third LED module 240 are disposed on the light source plate 100. In addition, a first white LED module 310 with high color temperature and a second white LED module 320 are disposed on the light source plate 100. An antenna module 600 is placed at the center of the light source plate 100.

In Fig. 3, a LED module 200 has a package frame 210 which is mounted with a first chip 223 and a second LED chip 221. There are wires 250 for connecting the electrodes of the first LED chip 223 and the second LED chip 221 to four pads 261, 262, 292, 293. The four pads 261, 262, 292, 293 are further electrically connected to external electrodes 270.

In Fig. 4, a cross section view of the example in Fig. 3 is provided. The same reference numerals refer to the same components.

Fig. 5 shows the conductive path routing for the LED chips 221, 222, 223 of the LED modules 230, 240. In Fig. 5, there are two LED modules with red LED chip and blue LED chip. In the example of Fig. 5, the same color LED chips are connected together. Different color LED chips are connected separately.

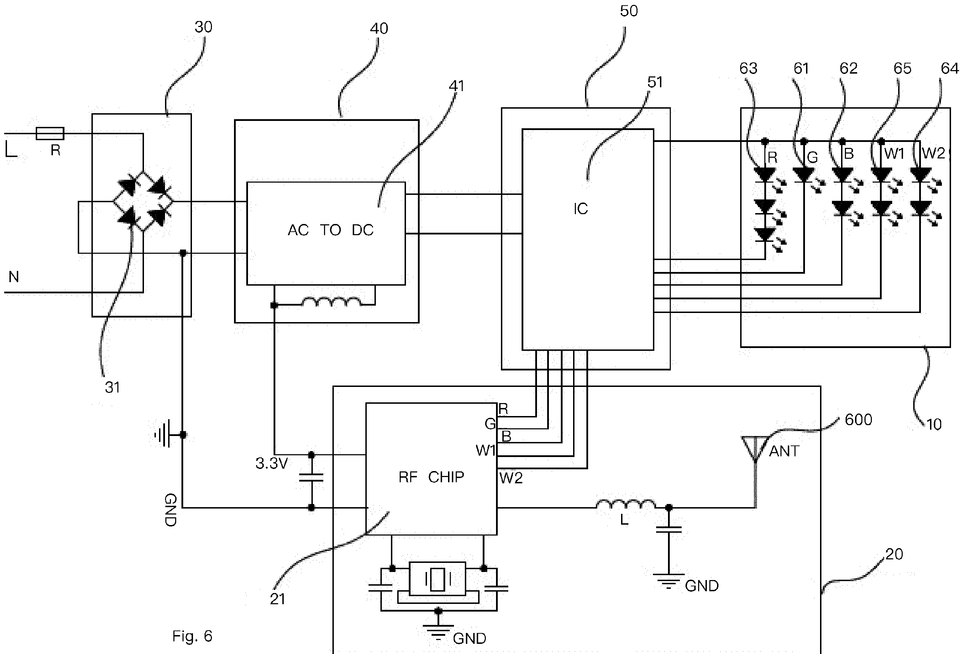

Fig. 6 shows a circuit diagram.

In Fig. 6, a rectifier 30 has a bridge circuit 31 for rectifying an input power source. A power circuit 40 has an AC-to-DC converter 41. A driver module 50 includes constant current chip 51.

There is a RF chip 21 as an antenna module 20. The antenna 600 is used for receiving an external command. A light source module 10 has LED modules 61, 63, 62, 65, 64.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings.

The embodiments were chosen and described in order to best explain the principles of the techniques and their practical applications. Others skilled in the art are thereby enabled to best utilize the techniques and various embodiments with various modifications as are suited to the particular use contemplated.

Although the disclosure and examples have been fully described with reference to the accompanying drawings, it is to be noted that various changes and modifications will become apparent to those skilled in the art.

## Claims

1. A lighting apparatus comprising:
a first LED module (8802), comprising only two LED chips (8803, 8804), namely a first LED chip (8803) and a second LED chip (8804), and a first package frame (8815) disposing the LED chips (8803, 8804);
a second LED module (8805) comprising only two LED chips (8806, 8807), namely a third LED chip (8806) and a fourth LED chip (8807), and a second package frame (8816) disposing the LED chips (8806, 8807);
a third LED module (8808) comprising only two LED chips (8809, 8810), namely a fifth LED chip (8809) and a sixth LED chip (8810), and a third package frame (8817) disposing the LED chips (8809, 8810); and
a light source plate (8801) configured for mounting the first LED module, the second LED module and the third LED module,
wherein a total number of red color type among the first LED chip (8803), the second LED chip (8804), the third LED chip (8806), the fourth LED chip (8807), the fifth LED chip (8809) and the sixth LED chip (8810) is more than a total number of green color type among the first LED chip (8803), the second LED chip (8804), the third LED chip (8806), the fourth LED chip (8807), the fifth LED chip (8809) and the sixth LED chip (8810),
wherein the total number of blue color type among the first LED chip (8803), the second LED chip (8804), the third LED chip (8806), the fourth LED chip (8807), the fifth LED chip (8809) and the sixth LED chip (8810) is more than the total number of green color type among the first LED chip (8803), the second LED chip (8804), the third LED chip (8806), the fourth LED chip (8807), the fifth LED chip (8809) and the sixth LED chip (8810),
**characterized in that**
the total number of red color type among the first LED chip (8803), the second LED chip (8804), the third LED chip (8806), the fourth LED chip (8807), the fifth LED chip (8809) and the sixth LED chip (8810) is more than a total number of blue color type among the first LED chip (8803), the second LED chip (8804), the third LED chip (8806), the fourth LED chip (8807), the fifth LED chip (8809) and the sixth LED chip (8810).

2. The lighting apparatus of claim 1, further comprising an antenna module (8955) disposed at a center of the light source plate (8801), wherein the antenna module (8955) has a protruding part from the light source plate (8801), the first LED module (8802), the second LED module (8805) and the third LED module (8808) are disposed surrounding the antenna module (8955).

3. The lighting apparatus of claim 2, wherein the antenna module has a reflective layer (8906) configured for reflecting a light of the first LED module (8802), the second LED module (8805) and the third LED module (8808).

4. The lighting apparatus of claim 2 or 3, wherein a fluorescent layer (8989) is disposed on the antenna module (8955).

5. The lighting apparatus of any one of claims 2-4, wherein the antenna module (8955) has a fourth LED module (8909, 8908).

6. The lighting apparatus of claim 5, wherein the fourth LED module (8909, 8908) is configured to emit a light to a light guide (8991) of the antenna module (8955).

7. The lighting apparatus of any one of claims 2 to 6, wherein a driver circuit is attached on the antenna module (8955).

8. The lighting apparatus of any one of claims 2 to 7, wherein the antenna module (8955) is adapted to receive an external command (8967) from an external device (8966) via the antenna module (8955) to activate an eye protection mode for lowering a light intensity of a blue LED device from the first LED module (8802), the second LED module (8805) and the third LED module (8808).

9. The lighting apparatus of any one of claims 2 to 8, wherein the antenna module (8955) is adapted to receive an external command (8967) of an external device (8966) from the antenna module (8955) to activate a sleep mode for lowering a light intensity of a blue LED device and increasing a light intensity of a red LED device of the first LED module (8802), the second LED module (8805) and the third LED module (8808).

10. The lighting apparatus of any one of claims 2 to 9, wherein the antenna module (8955) is adapted to receive an external command (8967) of an external device (8966) from the antenna module (8955) to activate a color rendering mode optimized for an object type by controlling light intensity parameters of the first LED module (8802), the second LED module (8805) and the third LED module (8808).

11. The lighting apparatus of any one of claims 1 to 10, wherein the first LED chip (8803) is a red color LED device, the second LED chip (8804) is a green color LED device, the third LED chip (8806) is a red LED device, the fourth LED chip (8807) is a blue LED device, the fifth LED chip (8809) is a red LED device, and the sixth LED chip (8810) is a blue LED device.

12. The lighting apparatus of claim 11, wherein the LED devices of the same color in the first LED module (8802), the second LED module (8805) and the third LED module (8808) are connected in series and controlled at the same time, the LED devices of different colors in the first LED module (8802), the second LED module (8805) and the third LED module (8808) are controlled separately.

13. The lighting apparatus of any one of claims 1 to 12, further comprising a first white LED module (310) with a first color temperature, wherein the first white LED module (310) is disposed on the light source plate.

## Patentansprüche

1. Beleuchtungsvorrichtung mit:
ein erstes LED-Modul (8802), das nur zwei LED-Chips (8803, 8804) umfasst, nämlich einen ersten LED-Chip (8803) und einen zweiten LED-Chip (8804), und einen ersten Gehäuserahmen (8815), der die LED-Chips (8803, 8804) aufnimmt;
ein zweites LED-Modul (8805), das nur zwei LED-Chips (8806, 8807) umfasst, nämlich einen dritten LED-Chip (8806) und einen vierten LED-Chip (8807), und einen zweiten Gehäuserahmen (8816), der die LED-Chips (8806, 8807) aufnimmt;
ein drittes LED-Modul (8808), das nur zwei LED-Chips (8809, 8810) umfasst, nämlich einen fünften LED-Chip (8809) und einen sechsten LED-Chip (8810), und einen dritten Gehäuserahmen (8817), der die LED-Chips (8809, 8810) aufnimmt; und
eine Lichtquellenplatte (8801), die zum Montieren des ersten LED-Moduls, des zweiten LED-Moduls und des dritten LED-Moduls konfiguriert ist,
wobei eine Gesamtzahl des roten Farbtyps unter dem ersten LED-Chip (8803), dem zweiten LED-Chip (8804), dem dritten LED-Chip (8806), dem vierten LED-Chip (8807), dem fünften LED-Chip (8809) und dem sechsten LED-Chip (8810) größer ist als eine Gesamtzahl des grünen Farbtyps unter dem ersten LED-Chip (8803), dem zweiten LED-Chip (8804), dem dritten LED-Chip (8806), dem vierten LED-Chip (8807), dem fünften LED-Chip (8809) und dem sechsten LED-Chip (8810),
wobei die Gesamtzahl des blauen Farbtyps unter dem ersten LED-Chip (8803), dem zweiten LED-Chip (8804), dem dritten LED-Chip (8806), dem vierten LED-Chip (8807), dem fünften LED-Chip (8809) und dem sechsten LED-Chip (8810) größer ist als die Gesamtzahl des grünen Farbtyps unter dem ersten LED-Chip (8803), dem zweiten LED-Chip (8804), dem dritten LED-Chip (8806), dem vierten LED-Chip (8807), dem fünften LED-Chip (8809) und dem sechsten LED-Chip (8810), **dadurch gekennzeichnet, dass**
die Gesamtzahl des roten Farbtyps unter dem ersten LED-Chip (8803), dem zweiten LED-Chip (8804), dem dritten LED-Chip (8806), dem vierten LED-Chip (8807), dem fünften LED-Chip (8809) und dem sechsten LED-Chip (8810) größer ist als eine Gesamtzahl des blauen Farbtyps unter dem ersten LED-Chip (8803), dem zweiten LED-Chip (8804), dem dritten LED-Chip (8806), dem vierten LED-Chip (8807), dem fünften LED-Chip (8809) und dem sechsten LED-Chip (8810).

2. Beleuchtungsvorrichtung nach Anspruch 1, die ferner ein Antennenmodul (8955) umfasst, das in der Mitte der Lichtquellenplatte (8801) angeordnet ist, wobei das Antennenmodul (8955) einen von der Lichtquellenplatte (8801) vorstehenden Teil aufweist und das erste LED-Modul (8802), das zweite LED-Modul (8805) und das dritte LED-Modul (8808) um das Antennenmodul (8955) herum angeordnet sind.

3. Beleuchtungsvorrichtung nach Anspruch 2, wobei das Antennenmodul eine rereflektierende Schicht (8906) aufweist, die so konfiguriert ist, dass sie ein Licht des ersten LED-Moduls (8802), des zweiten LED-Moduls (8805) und des dritten LED-Moduls (8808) reflektiert.

4. Die Beleuchtungsvorrichtung nach Anspruch 2 oder 3, wobei eine fluoreszierende Schicht (8989) auf dem Antennenmodul (8955) angeordnet ist.

5. Beleuchtungsvorrichtung nach einem der Ansprüche 2 bis 4, wobei das Antennenmodul (8955) ein viertes LED-Modul (8909, 8908) aufweist.

6. Beleuchtungsvorrichtung nach Anspruch 5, wobei das vierte LED-Modul (8909, 8908) so konfiguriert ist, dass es ein Licht zu einem Lichtleiter (8991) des Antennenmoduls (8955) emittiert.

7. Beleuchtungsvorrichtung nach einem der Ansprüche 2 bis 6, wobei eine Treiberschaltung an dem Antennenmodul (8955) angebracht ist.

8. Beleuchtungsvorrichtung nach einem der Ansprüche 2 bis 7, wobei das Antennenmodul (8955) so ausgelegt ist, dass es einen externen Befehl (8967) von einer externen Vorrichtung (8966) über das Antennenmodul (8955) empfängt, um einen Augenschutzmodus zum Absenken der Lichtintensität einer blauen LED-Vorrichtung des ersten LED-Moduls (8802), des zweiten LED-Moduls (8805) und des dritten LED-Moduls (8808) zu aktivieren.

9. Beleuchtungsvorrichtung nach einem der Ansprüche 2 bis 8, wobei das Antennenmodul (8955) so ausgelegt ist, dass es einen externen Befehl (8967) einer externen Vorrichtung (8966) von dem Antennenmodul (8955) empfängt, um einen Schlafmodus zum Verringern einer Lichtintensität einer blauen LED-Vorrichtung und zum Erhöhen einer Lichtintensität einer roten LED-Vorrichtung des ersten LED-Moduls (8802), des zweiten LED-Moduls (8805) und des dritten LED-Moduls (8808) zu aktivieren.

10. Beleuchtungsvorrichtung nach einem der Ansprüche 2 bis 9, wobei das Antennenmodul (8955) so ausgelegt ist, dass es einen externen Befehl (8967) einer externen Vorrichtung (8966) von dem Antennenmodul (8955) empfängt, um einen Farbwiedergabemodus zu aktivieren, der für einen Objekttyp optimiert ist, indem Lichtintensitätsparameter des ersten LED-Moduls (8802), des zweiten LED-Moduls (8805) und des dritten LED-Moduls (8808) gesteuert werden.

11. Beleuchtungsvorrichtung nach einem der Ansprüche 1 bis 10, wobei der erste LED-Chip (8803) eine rote Farb-LED-Vorrichtung ist, der zweite LED-Chip (8804) eine grüne Farb-LED-Vorrichtung ist, der dritte LED-Chip (8806) eine rote LED-Vorrichtung ist, der vierte LED-Chip (8807) eine blaue LED-Vorrichtung ist, der fünfte LED-Chip (8809) eine rote LED-Vorrichtung ist und der sechste LED-Chip (8810) eine blaue LED-Vorrichtung ist.

12. Beleuchtungsvorrichtung nach Anspruch 11, wobei die LED-Vorrichtungen derselben Farbe in dem ersten LED-Modul (8802), dem zweiten LED-Modul (8805) und dem dritten LED-Modul (8808) in Reihe geschaltet sind und gleichzeitig gesteuert werden, während die LED-Vorrichtungen verschiedener Farben in dem ersten LED-Modul (8802), dem zweiten LED-Modul (8805) und dem dritten LED-Modul (8808) getrennt gesteuert werden.

13. Beleuchtungsvorrichtung nach einem der Ansprüche 1 bis 12, die ferner ein erstes weißes LED-Modul (310) mit einer ersten Farbtemperatur umfasst, wobei das erste weiße LED-Modul (310) auf der Lichtquellenplatte angeordnet ist.

## Revendications

1. Appareil d'éclairage comprenant
un premier module LED (8802), comprenant seulement deux puces LED (8803, 8804), à savoir une première puce LED (8803) et une deuxième puce LED (8804), et un premier cadre de boîtier (8815) contenant les puces LED (8803, 8804) ;
un deuxième module LED (8805) comprenant seulement deux puces LED (8806, 8807), à savoir une troisième puce LED (8806) et une quatrième puce LED (8807), et un deuxième cadre de boîtier (8816) contenant les puces LED (8806, 8807) ;
un troisième module LED (8808) comprenant seulement deux puces LED (8809, 8810), à savoir une cinquième puce LED (8809) et une sixième puce LED (8810), et un troisième cadre d'emballage (8817) contenant les puces LED (8809, 8810) ; et une plaque de source lumineuse (8801) configurée pour monter le premier module LED, le deuxième module LED et le troisième module LED,
dans lequel le nombre total de types de couleur rouge parmi la première puce LED (8803), la deuxième puce LED (8804), la troisième puce LED (8806), la quatrième puce LED (8807), la cinquième puce LED (8809) et la sixième puce LED (8810) est supérieur au nombre total de types de couleur verte parmi la première puce LED (8803), la deuxième puce LED (8804), la troisième puce LED (8806), la quatrième puce LED (8807), la cinquième puce LED (8809) et la sixième puce LED (8810), dans lequel le nombre total de types de couleur bleue parmi la première puce LED (8803), la deuxième puce LED (8804), la troisième puce LED (8806), la quatrième puce LED (8807), la cinquième puce LED (8809) et la sixième puce LED (8810) est supérieur au nombre total de types de couleur verte parmi la première puce LED (8803), la deuxième puce LED (8804), la troisième puce LED (8806), la quatrième puce LED (8807), la cinquième puce LED (8809) et la sixième puce LED (8810), **caractérisés par le fait que**
le nombre total de types de couleur rouge parmi la première puce LED (8803), la deuxième puce LED (8804), la troisième puce LED (8806), la quatrième puce LED (8807), la cinquième puce LED (8809) et la sixième puce LED (8810) est supérieur au nombre total de types de couleur bleue parmi la première puce LED (8803), la deuxième puce LED (8804), la troisième puce LED (8806), la quatrième puce LED (8807), la cinquième puce LED (8809) et la sixième puce LED (8810).

2. L'appareil d'éclairage de la revendication 1, comprenant en outre un module d'antenne (8955) disposé au centre de la plaque de source lumineuse (8801), dans lequel le module d'antenne (8955) a une partie saillante de la plaque de source lumineuse (8801), le premier module LED (8802), le deuxième module LED (8805) et le troisième module LED (8808) sont disposés autour du module d'antenne (8955).

3. L'appareil d'éclairage de la revendication 2, dans lequel le module d'antenne possède une couche rétroréfléchissante (8906) configurée pour réfléchir la lumière du premier module LED (8802), du deuxième module LED (8805) et du troisième module LED (8808).

4. L'appareil d'éclairage de la revendication 2 ou 3, dans lequel une couche fluorescente (8989) est disposée sur le module d'antenne (8955).

5. L'appareil d'éclairage de l'une des revendications 2 à 4, dans lequel le module d'antenne (8955) comporte un quatrième module LED (8909, 8908).

6. L'appareil d'éclairage de la revendication 5, dans lequel le quatrième module LED (8909, 8908) est configuré pour émettre une lumière vers un guide de lumière (8991) du module d'antenne (8955).

7. L'appareil d'éclairage de l'une des revendications 2 à 6, dans lequel un circuit d'attaque est fixé sur le module d'antenne (8955).

8. L'appareil d'éclairage de l'une des revendications 2 à 7, dans lequel le module d'antenne (8955) est adapté pour recevoir une commande externe (8967) d'un dispositif externe (8966) via le module d'antenne (8955) afin d'activer un mode de protection des yeux pour réduire l'intensité lumineuse d'un dispositif LED bleu du premier module LED (8802), du deuxième module LED (8805) et du troisième module LED (8808).

9. L'appareil d'éclairage de l'une des revendications 2 à 8, dans lequel le module d'antenne (8955) est adapté pour recevoir une commande externe (8967) d'un dispositif externe (8966) du module d'antenne (8955) afin d'activer un mode veille pour réduire l'intensité lumineuse d'un dispositif LED bleue et augmenter l'intensité lumineuse d'un dispositif LED rouge du premier module LED (8802), du deuxième module LED (8805) et du troisième module LED (8808).

10. L'appareil d'éclairage de l'une des revendications 2 à 9, dans lequel le module d'antenne (8955) est adapté pour recevoir une commande externe (8967) d'un dispositif externe (8966) du module d'antenne (8955) pour activer un mode de rendu des couleurs optimisé pour un type d'objet en contrôlant les paramètres d'intensité lumineuse du premier module LED (8802), du deuxième module LED (8805) et du troisième module LED (8808).

11. L'appareil d'éclairage de l'une des revendications 1 à 10, dans lequel la première puce LED (8803) est un dispositif LED de couleur rouge, la deuxième puce LED (8804) est un dispositif LED de couleur verte, la troisième puce LED (8806) est un dispositif LED rouge, la quatrième puce LED (8807) est un dispositif LED bleu, la cinquième puce LED (8809) est un dispositif LED rouge, et la sixième puce LED (8810) est un dispositif LED bleu.

12. L'appareil d'éclairage de la revendication 11, dans lequel les dispositifs LED de même couleur dans le premier module LED (8802), le deuxième module LED (8805) et le troisième module LED (8808) sont connectés en série et commandés en même temps, les dispositifs LED de couleurs différentes dans le premier module LED (8802), le deuxième module LED (8805) et le troisième module LED (8808) sont commandés séparément.

13. L'appareil d'éclairage de l'une des revendications 1 à 12, comprenant en outre un premier module LED blanc (310) avec une première température de couleur, dans lequel le premier module LED blanc (310) est disposé sur la plaque de la source lumineuse.
